# EUROPEAN PATENT SPECIFICATION

(11) **EP 4 346 359 B1**
(45) Date of publication and mention of the grant of the patent: **29.01.2025**
(21) Application number: 23192855.7
(22) Date of filing: 23.08.2023
(51) Int. Cl.: H10N 30/00, H10N 30/853, H10N 30/50

(54) **PIEZOELECTRIC ELEMENT AND ACTUATOR**
PIEZOELEKTRISCHES ELEMENT UND AKTUATOR
ÉLÉMENT PIÉZOÉLECTRIQUE ET ACTIONNEUR

(30) Priority: 30.09.2022 JP 2022158868
(43) Date of publication of application: 03.04.2024
(73) Proprietor: FUJIFILM Corporation, Tokyo 106-8620 (JP)
(72) Inventor: NAKAMURA, Seigo, No. 577, Ushijima, Kaisei-machi, Ashigarakami-gun, Kanagawa, 258-8577 (JP); KOBAYASHI, Hiroyuki, No. 577, Ushijima, Kaisei-machi, Ashigarakami-gun, Kanagawa, 258-8577 (JP); SUGIMOTO, Shinya, No. 577, Ushijima, Kaisei-machi, Ashigarakami-gun, Kanagawa, 258-8577 (JP); SASAKI, Tsutomu, No. 577, Ushijima, Kaisei-machi, Ashigarakami-gun, Kanagawa, 258-8577 (JP)
(74) Representative: HGF

(56) References cited:
- DE-A1- 102018 203 812
- US-A1- 2013 099 627
- US-A1- 2013 229 465

## Description

### BACKGROUND

### 1. Technical Field

The present disclosure relates to a piezoelectric element and an actuator.

### 2. Description of the Related Art

As a material having excellent piezoelectric characteristics and excellent ferroelectricity, there is known a perovskite-type oxide such as lead zirconate titanate (Pb(Zr,Ti)O₃, hereinafter referred to as PZT). A piezoelectric body consisting of a perovskite-type oxide is applied as a piezoelectric film in a piezoelectric element comprising a lower electrode, a piezoelectric film, and an upper electrode on a substrate. This piezoelectric element has been developed into various devices such as a memory, an inkjet head (an actuator), a micromirror device, an angular velocity sensor, a gyro sensor, a piezoelectric micromachined ultrasonic transducer (PMUT), and an oscillation power generation device.

As the piezoelectric element, in order to obtain high piezoelectric characteristics, a multilayered piezoelectric element in which a plurality of piezoelectric films are laminated via an electrode layer has been proposed.

For example, JP2013-80886A proposes a piezoelectric element in which a first electrode, a Nb-doped PZT film, a second electrode, a Nb-doped PZT film, and a third electrode are laminated in this order. It is known that the Nb-doped PZT film has a direction of a spontaneous polarization that is aligned upward with respect to the substrate during film formation. That is, both of two layers of Nb-doped PZT films in JP2013-80886A have a spontaneous polarization of which a direction is aligned upward. In general, for the piezoelectric film having the spontaneous polarization of which a direction is aligned, higher piezoelectric performance can be obtained by applying an electric field in the same direction as the direction of the spontaneous polarization. Therefore, in JP2013-80886A, the electric field in the same direction as the direction of the spontaneous polarization is applied to each of two Nb-doped PZT films by a first driving method in which a second electrode is grounded, a positive potential (+V) is applied to a first electrode, and a negative potential (-V) is applied to a third electrode for driving, a second driving method in which the first electrode is grounded, a negative potential (-V) is applied to the second electrode, and a negative potential (-2V) that is larger in absolute value than that of the second electrode is applied to the third electrode for driving, or the like. As a result, a displacement amount that is substantially twice that of the piezoelectric element having only one layer is realized.

Further, JP2013-80887A proposes a piezoelectric element in which a first electrode, a first piezoelectric film, a second electrode, a second piezoelectric film, and a third electrode are laminated in this order, and a direction in which a spontaneous polarization of the first piezoelectric film is aligned and a direction in which a spontaneous polarization of the second piezoelectric film is aligned are different from each other. Further, as a specific example, a case where the first piezoelectric film is a Nb-doped PZT film and the second piezoelectric film is a PZT film without Nb addition (hereinafter, referred to as pure PZT) is illustrated. The Nb-doped PZT film has a direction of the spontaneous polarization which is aligned in a state in which a poling treatment is not performed, and the pure PZT film has a direction of the spontaneous polarization which is not aligned in a state in which the poling treatment is not performed. Therefore, by performing the poling treatment on the pure PZT film such that the spontaneous polarization is aligned in a direction opposite to the direction of the spontaneous polarization of the Nb-doped PZT film, the direction of the spontaneous polarization of the first piezoelectric film and the direction of the spontaneous polarization of the second piezoelectric film are made different. In JP2013-80887A, by setting the first electrode and the third electrode of the piezoelectric element to have the same potential and using the second electrode as a drive electrode, an electric field in the same direction as the direction of the spontaneous polarization is applied to each of the first piezoelectric film and the second piezoelectric film. Accordingly, piezoelectric performance corresponding to two layers of piezoelectric films can be obtained with a voltage large enough to drive one layer of piezoelectric film, so that high piezoelectric performance can be obtained at a low voltage.

### SUMMARY

However, in JP2013-80886A, in order to obtain piezoelectric performance equivalent to that of the first driving method in the second driving method in which a voltage having an absolute value larger than that of the second electrode is applied to the third electrode, it is necessary to apply a very large voltage to the third electrode and sufficient piezoelectric performance cannot be obtained at a low voltage. In order to carry out the first driving method in which voltages of different signs are applied to the first electrode and the third electrode, it is necessary to provide a positive drive circuit and a negative drive circuit, which leads to high costs.

In addition, in the piezoelectric element of JP2013-80887A, very good piezoelectric performance can be obtained. However, in order to manufacture the piezoelectric element of JP2013-80887A, for example, the first piezoelectric film and the second piezoelectric film need to be composed of piezoelectric films containing different materials such that the first piezoelectric film is a Nb-doped PZT film and the second piezoelectric film is a pure PZT film. Therefore, in order to form the first piezoelectric film and the second piezoelectric film, two different targets are required, and at least one of the piezoelectric films needs to be subjected to the poling treatment, so that sufficient cost reduction cannot be achieved.

As described above, the piezoelectric element that can obtain high piezoelectric performance is expensive or requires application of a high voltage, and a low-cost piezoelectric element that can obtain high piezoelectric performance at a low voltage has not been realized.

An object of the present disclosure is to provide a piezoelectric element and a piezoelectric actuator capable of obtaining high piezoelectric performance at a low voltage at low costs.

A piezoelectric element according to an aspect of the present disclosure comprises a substrate; and a first electrode, a first piezoelectric film, a second electrode, a second piezoelectric film, and a third electrode which are provided on the substrate in this order, in which both the first piezoelectric film and the second piezoelectric film contain a perovskite-type oxide containing Pb at an A site and containing Zr, Ti, and M at a B site as a main component, where M is a metal element selected from V, Nb, Ta, Sb, Mo, and W, in a case where a Pb composition ratio in the perovskite-type oxide is defined by Pb/(Zr + Ti + M), where element symbols each represent a molar ratio, the Pb composition ratio in the first piezoelectric film is different from the Pb composition ratio in the second piezoelectric film, both the first piezoelectric film and the second piezoelectric film have spontaneous polarizations aligned in a film thickness direction, and directions of the spontaneous polarizations of the first piezoelectric film and the second piezoelectric film are the same, and polarization-electric field hysteresis measured for the first piezoelectric film with the first electrode grounded and the second electrode as a drive electrode, and polarization-electric field hysteresis measured for the second piezoelectric film with the second electrode grounded and the third electrode as a drive electrode are shifted in the same electric field direction with respect to origins thereof.

It is preferable that at the B sites of the perovskite-type oxides contained in the first piezoelectric film and the second piezoelectric film, Zr composition ratios represented by Zr/(Zr + Ti), Ti composition ratios represented by Ti/(Zr + Ti), and M composition ratios represented by M/(Zr + Ti + M) are the same, respectively.

It is preferable that in a case where the metal element M is Nb and the M composition ratio at the B site is y, 0.08 ≤ y ≤ 0.15 is satisfied.

It is preferable that the Pb composition ratio of the perovskite-type oxide contained in the first piezoelectric film and the Pb composition ratio of the perovskite-type oxide contained in the second piezoelectric film differ from each other by 0.01 or more.

It is preferable that, out of the first piezoelectric film and the second piezoelectric film, a film thickness of the piezoelectric film having a relatively small Pb composition ratio is thinner than a film thickness of the piezoelectric film having a relatively large Pb composition ratio by 100 nm or more.

It is preferable that the film thickness of the piezoelectric film having a relatively small Pb composition ratio is 1.5 µm or less.

It is preferable that the film thickness of the piezoelectric film having a relatively large Pb composition ratio is 2 µm or less.

It is preferable that the first electrode and the third electrode are connected to each other.

It is preferable that, out of the first piezoelectric film and the second piezoelectric film, an electric field in the same direction as the direction of the spontaneous polarization is applied to the piezoelectric film having a relatively large Pb composition ratio, and an electric field in a direction opposite to the direction of the spontaneous polarization is applied to the piezoelectric film having a relatively small Pb composition ratio.

An actuator according to another aspect of the present disclosure is an actuator comprising: the piezoelectric element according to the aspect of the present disclosure; and a drive circuit that applies a drive voltage to the piezoelectric element, in which the drive circuit applies an electric field in the same direction as the direction of the spontaneous polarization to the piezoelectric film having a relatively large Pb composition ratio, and applies an electric field in a direction opposite to the direction of the spontaneous polarization to the piezoelectric film having a relatively small Pb composition ratio, out of the first piezoelectric film and the second piezoelectric film.

According to a technology of the present disclosure, it is possible to provide a piezoelectric element and an actuator capable of obtaining high piezoelectric performance at a low voltage at low costs.

### BRIEF DESCRIPTION OF THE DRAWINGS

Fig. 1 is a cross-sectional view of a piezoelectric element according to one embodiment.
Fig. 2A is a diagram showing a polarization-voltage hysteresis curve of a piezoelectric film having a relatively large Pb composition ratio.
Fig. 2B is a diagram showing a polarization-voltage hysteresis curve of a piezoelectric film having a relatively small Pb composition ratio.
Fig. 3 is a diagram showing a schematic configuration of an actuator.
Fig. 4 is a diagram showing a schematic configuration of an actuator of a modification example.
Fig. 5 is a diagram showing a schematic configuration of a piezoelectric element and an actuator of a modification example.
Fig. 6 is a cross-sectional view of a piezoelectric element of a modification example.
Fig. 7 is a diagram for explaining a problem of a multilayered piezoelectric element.
Fig. 8A is a hysteresis curve of a first piezoelectric film 14f.
Fig. 8B is a hysteresis curve of a second piezoelectric film 18f.
Fig. 8C is a diagram showing a displacement amount with respect to a voltage of a piezoelectric element 101.
Fig. 9 is an explanatory diagram of an effect of the piezoelectric element according to the present embodiment.
Fig. 10 is an explanatory diagram of an effect of a piezoelectric element according to the present embodiment.
Fig. 11 is a graph showing a voltage dependence of a piezoelectric constant d₃₁ in a low voltage region for Comparative Example 6, Example 1, and Example 6.
Fig. 12 is a diagram showing a polarization-voltage hysteresis curve of the second piezoelectric film of Comparative Example 6 and Example 1.
Fig. 13 is a diagram showing a polarization-voltage hysteresis curve of the second piezoelectric film of Comparative Example 6, Example 1, and Example 6.

### DESCRIPTION OF EMBODIMENTS

Hereinafter, embodiments according to the present invention will be described with reference to the drawings. In the drawings below, a layer thickness of each of layers and a ratio therebetween are depicted with appropriate changes for easy visibility, and thus they do not necessarily reflect the actual layer thickness and ratio.

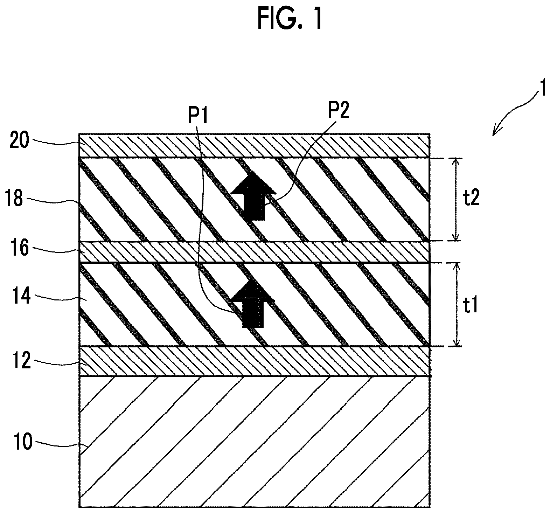

Fig. 1 is a cross-sectional schematic view showing a layer configuration of a piezoelectric element according to one embodiment. As shown in Fig. 1, a piezoelectric element 1 comprises a first electrode 12, a first piezoelectric film 14, a second electrode 16, a second piezoelectric film 18, and a third electrode 20 on a substrate 10 in this order.

The substrate 10 is not particularly limited, and examples thereof include silicon, glass, stainless steel, yttrium-stabilized zirconia, alumina, sapphire, silicon carbide, or other substrates. As the substrate 10, a laminated substrate such as a thermal oxide film-attached silicon substrate having a SiO₂ oxide film formed on a surface of a silicon substrate may be used. Further, as the substrate 10, a resin substrate such as polyethylene terephthalate (PET), polyethylene naphthalata (PEN), polyimide, and the like may be used.

The first electrode 12 is formed on the substrate 10. The main component of the first electrode 12 is not particularly limited, and examples thereof include metals such as gold (Au), platinum (Pt), iridium (Ir), ruthenium (Ru), titanium (Ti), molybdenum (Mo), tantalum (Ta), and aluminum (Al) or metal oxides, and combinations thereof. In addition, indium tin oxide (ITO), LaNiO₃, SrRuOs (SRO), or the like may be used.

The second electrode 16 is laminated on the first piezoelectric film 14, and the third electrode 20 is laminated on the second piezoelectric film 18. The first electrode 12 and the second electrode 16 are paired with each other to apply an electric field to the first piezoelectric film 14. In addition, the second electrode 16 and the third electrode 20 are paired with each other to apply an electric field to the second piezoelectric film 18.

The main components of the second electrode 16 and the third electrode 20 are not particularly limited, and examples thereof include, in addition to the materials exemplified for the first electrode 12, electrode materials that are generally used in a semiconductor process such as chromium (Cr) and combinations thereof. However, it is preferable to use an oxide conductor for the layer in contact with the first piezoelectric film 14 or the second piezoelectric film 18. Specific examples of an oxide conductor layer include indium tin oxide (ITO), Ir oxide, and SrRuOs (SRO), as well as LaNiO₃ and a doped ZnO.

The thicknesses of the first electrode 12, the second electrode 16, and the third electrode 20 are not particularly limited and are preferably about 50 nm to 300 nm, and more preferably 100 nm to 300 nm.

The first piezoelectric film 14 and the second piezoelectric film 18 are piezoelectric films in which a direction of a spontaneous polarization is aligned in a film thickness direction immediately after film formation and have, as main components, perovskite-type oxides which are represented by General Formula ABO₃ and contain lead (Pb) at an A site, and zirconium (Zr), titanium (Ti), and a metal element M at a B site. This perovskite-type oxide is represented by the following general formula.

Pbₐ{(ZrₓTi₁₋ₓ)_{1-y}M_{y}}O₃

Here, the metal element M is preferably one or more elements selected from vanadium (V), niobium (Nb), tantalum (Ta), antimony (Sb), molybdenum (Mo), and tungsten (W). Hereinafter, Pbₐ{(ZrₓTi₁₋ₓ)_{1-y}M_{y}}O₃ will be referred to as M-doped PZT. In addition, for example, in a case where the metal element M is Nb, it is referred to as Nb-doped PZT.

The metal element M may be a single element such as V only or Nb only, or it may be a combination of two or three or more elements, such as a mixture of V and Nb or a mixture of V, Nb, and Ta. In a case where the metal element M is these elements, a very high piezoelectric constant can be realized in combination with Pb of the A site element.

In particular, Pbₐ{(ZrₓTi₁₋ₓ)_{1-y}Nb_{y}}O₃ in which the metal element M is Nb, that is, Nb-doped PZT is optimal. Here, it is preferable that 0.08 ≤ y ≤ 0.15. A higher piezoelectric constant can be obtained with 0.08 ≤ y. In a case of forming a piezoelectric film by a vapor phase growth method such as sputtering using Nb-doped PZT in which M is Nb, a piezoelectric film having a very high piezoelectric constant having more aligned spontaneous polarization upward from the substrate 10 can be obtained. In addition, in this specification, with reference to the substrate 10, a direction away from the substrate 10 is defined as upward, and a substrate side is defined as downward.

Here, the main component means a component that occupies 80 mol% or more. It is preferable that 90 mol% or more of each of the first piezoelectric film 14 and the second piezoelectric film 18 is occupied by the perovskite-type oxide, and it is more preferable that the first piezoelectric film 14 and the second piezoelectric film 18 are composed of the perovskite-type oxide (however, containing unavoidable impurities).

A Pb composition ratio a in the perovskite-type oxide is defined by a = Pb/(Zr + Ti + M) where element symbols each represent a molar ratio.

Similarly, a Zr composition ratio x at the B site of the perovskite-type oxide is x = Zr/(Zr + Ti), a Ti composition ratio 1-x is 1-x = Ti/(Zr + Ti), and an M composition ratio y which is a compositional ratio of the metal element M at the B site is y = M/(Zr + Ti + M). Here, element symbols in the formula each represent a molar ratio.

In the piezoelectric element 1, in a case where the Pb composition ratio of the perovskite-type oxide in the first piezoelectric film 14 is denoted by a1, and the Pb composition ratio of the perovskite-type oxide in the second piezoelectric film 18 is denoted by a2, a1 and a2 are different. The difference between a1 and a2 means that there is a difference greater than or equal to a measurement error. As a method for measuring the composition, there are a plurality of analysis methods such as inductively coupled plasma (ICP) emission spectroscopy or X-ray fluorescence (XRF). For example, in a case where composition analysis is performed by XRF, a measurement error is about 0.005. It is preferable that a1 and a2 differ by 0.01 or more, that is, |a1 - a2| ≥ 0.01.

In addition, it is preferable that the Zr composition ratios, the Ti composition ratios, and the M composition ratios of the perovskite-type oxides contained in the first piezoelectric film 14 and the second piezoelectric film 18 are the same, respectively. That is, in a case where, in the perovskite-type oxide in the first piezoelectric film 14, the Zr composition ratio at the B site is denoted by x1, the M composition ratio at the B site is denoted by y1, and in the perovskite-type oxide in the second piezoelectric film 18, the Zr composition ratio at the B site is dented by x2, and the M composition ratio at the B site is denoted by y2, it is preferable that x1 and x2 are the same, and y1 and y2 are the same. Here, "same" means that they are equal within a range of a measurement error.

It is said that, in the PZT-based perovskite-type oxide, high piezoelectric characteristics are exhibited at a morphotropic phase boundary (MPB) and its vicinity. A Zr/Ti molar ratio of around 55/45 is the MPB composition, and in the above general formula, the MPB composition or its vicinity is preferable. The "MPB or its vicinity" refers to a region in which a phase transition occurs in a case where an electric field is applied to the piezoelectric film. Specifically, Zr:Ti (molar ratio) is preferably in a range of 45:55 to 55:45, that is, in a range of x = 0.45 to 0.55.

A film thickness t1 of the first piezoelectric film 14 and a film thickness t2 of the second piezoelectric film 18 are preferably 0.2 µm or more and 5 µm or less, and more preferably 1 µm or more. The film thicknesses of the first piezoelectric film 14 and the second piezoelectric film 18 may be the same as or different from each other. However, it is preferable that, out of the first piezoelectric film 14 and the second piezoelectric film 18, the film thickness of the piezoelectric film having a relatively small Pb composition ratio is thinner than the film thickness of the piezoelectric film having a relatively large Pb composition ratio by 100 nm or more. In this case, the film thickness of the piezoelectric film having a relatively small Pb composition ratio is preferably 1.5 µm or less. In addition, the film thickness of the piezoelectric film having a relatively large Pb composition ratio is preferably 2 µm or less.

Both the first piezoelectric film 14 and the second piezoelectric film 18 have the spontaneous polarization aligned in the film thickness direction, and a direction of a spontaneous polarization P1 of the first piezoelectric film 14 and a direction of a spontaneous polarization P2 of the second piezoelectric film 18 are the same. In the example shown in Fig. 1, the direction of the spontaneous polarization P1 of the first piezoelectric film 14 and the direction of the spontaneous polarization P2 of the second piezoelectric film 18 are both upward in the film thickness direction. Whether or not the spontaneous polarization in the piezoelectric film is aligned and the direction in which the spontaneous polarization is aligned can be confirmed by measuring a P-E hysteresis (or P-V hysteresis) curve indicating the polarization-electric field characteristic (or polarization-voltage characteristic) of the piezoelectric film.

In the piezoelectric film that has not been subjected to the poling treatment, the reason why the direction of the spontaneous polarization is aligned in a state in which an external electric field is not applied is thought to be due to generation of an electric field caused by distortion or defect of a crystal structure (hereinafter referred to as a spontaneous internal electric field) in the piezoelectric film. In a case of a piezoelectric film in which a spontaneous internal electric field is not generated in a state in which an external electric field is not applied, the P-E hysteresis curve (or P-V hysteresis curve) depicts a shape whose center coincides with an origin. On the other hand, in a case of a piezoelectric film in which a spontaneous internal electric field is generated, that is, a piezoelectric film in which the direction of the spontaneous polarization is aligned in a state in which the external electric field is not applied, the center of the hysteresis curve is deviated (shifted) from the origin because the direction of the spontaneous polarization is aligned with respect to the spontaneous internal electric field. In a case of the P-E hysteresis curve, assuming that the spontaneous internal electric field is Ei and the external electric field applied from the outside is Eo, an electric field of Ei + Eo is applied, so that the center of the hysteresis curve is shifted from the origin by an amount of the spontaneous internal electric field Ei. In a case of the P-V hysteresis curve, the center of the hysteresis curve is shifted from the origin by the product of Ei and the film thickness. Therefore, in a case where the center of the measured hysteresis curve is shifted from the origin, it can be considered that the spontaneous internal electric field is generated and the spontaneous polarization is aligned. The amount of shift of the center of the hysteresis curve from the origin is proportional to a degree of alignment of the spontaneous polarization, and a larger shift amount means that the degree of alignment of the spontaneous polarization is higher (the spontaneous internal electric field is larger). In addition, it is possible to specify the direction of the spontaneous polarization that is aligned by a shift direction of the hysteresis curve from the origin. In a case of the P-V hysteresis curve, the center of the hysteresis curve is defined as a midpoint between two coercive voltages described below.

Hereinafter, the term "direction of the spontaneous polarization" means the direction of the spontaneous polarization aligned by the spontaneous internal electric field.

The present inventors have found that in the M-doped PZT film, the degree of alignment of the spontaneous polarization can be changed by changing the Pb composition ratio. Increasing the Pb composition ratio tends to increase the degree of alignment of the spontaneous polarization. Although a mechanism by which the degree of alignment of the spontaneous polarization changes depending on the Pb composition ratio is not clear, it is presumed that defects in Pb, which is the A site of the perovskite-type structure, are related to the degree of alignment of the spontaneous polarization. It is considered that the Pb composition ratio correlates with the amount of Pb defects, and the degree of alignment of the spontaneous polarization changes depending on the Pb composition ratio, and as a result, a coercive electric field changes.

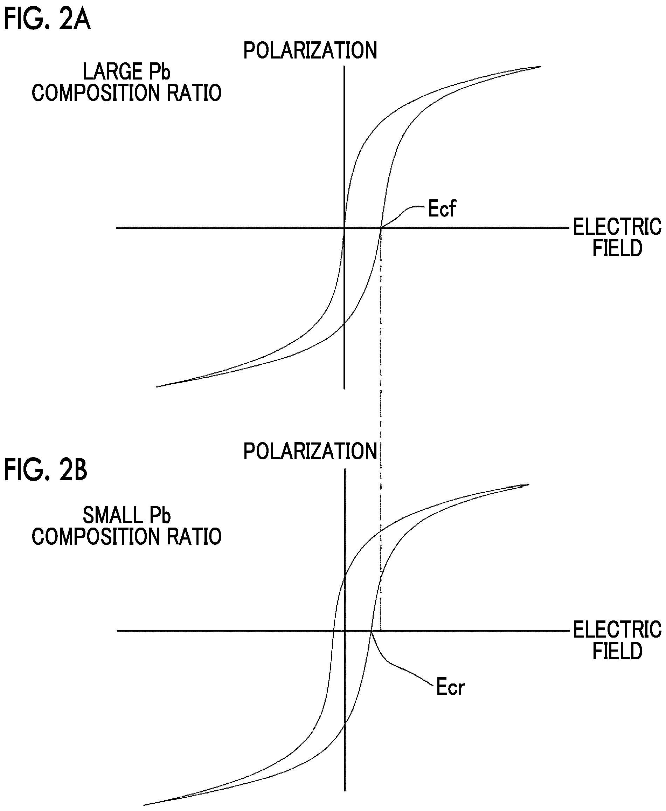

Fig. 2A shows a P-E hysteresis curve showing polarization-electric field (P-E) characteristics for a piezoelectric film having a relatively large Pb composition ratio out of the first piezoelectric film 14 and the second piezoelectric film 18, and Fig. 2B shows a P-E hysteresis curve for a piezoelectric film having a relatively small Pb composition ratio. In addition, Figs. 2A and 2B show the hysteresis in a case where an electrode of the piezoelectric film to be measured on the substrate side is grounded, an upper electrode is used as a drive electrode, and a sweep voltage is applied to the piezoelectric film to perform measurement.

In both the hysteresis shown in Fig. 2A and the hysteresis shown in Fig. 2B, the center is shifted from the origin to the positive electric field side. The coercive electric field Ecr on the positive side of the hysteresis shown in Fig. 2B is smaller than the coercive electric field Ecf on the positive side of the hysteresis shown in Fig. 2A. The coercive electric field is an electric field in which the polarization is 0, and is a voltage at which the polarization is reversed. This means that in a case where an electric field in a direction opposite to the direction of the spontaneous polarization is applied to the piezoelectric film having a relatively small Pb composition ratio, an electric field intensity required for reversing the polarization is smaller than that of the piezoelectric film having a relatively large Pb composition ratio.

The piezoelectric element 1 is two layers of piezoelectric films including the M-doped PZT, in which the two layers of piezoelectric films having the spontaneous polarizations which are aligned in the same direction in the film thickness direction are laminated with an electrode interposed therebetween, and the Pb composition ratios of the two layers of piezoelectric films are different from each other. With this configuration, higher piezoelectric performance can be obtained in a low voltage region as compared with a piezoelectric element comprising two layers of piezoelectric films having the same Pb composition ratio. Here, the low voltage region refers to a voltage region suitable for a case where the piezoelectric element is assumed to be incorporated in a consumer device, and specifically, a voltage region with an absolute value of 12 V or less. It is preferable that high piezoelectric performance can be obtained at a voltage of 7 V or less, and further 5 V or less.

By changing the Pb composition ratio as described above, the coercive electric field of the piezoelectric film to which the electric field in a direction opposite to the direction of the spontaneous polarization is applied can be made smaller than the coercive electric field of the piezoelectric film to which the electric field in the same direction as the direction of the spontaneous polarization is applied, and as a result, high piezoelectric performance can be obtained in a low voltage region, although details will be described later.

The first piezoelectric film 14 and the second piezoelectric film 18 have the spontaneous polarizations P1 and P2 aligned in the same direction, and in a case where an electric field in the same direction as the direction of the spontaneous polarization P1 is applied to one of the piezoelectric films and an electric field in a direction opposite to the direction of the spontaneous polarization P2 is applied to the other of the piezoelectric films, the electric field may be applied by using the first electrode 12 and the third electrode 20 as the same pole, and using the second electrode 16 as a different pole from the first electrode 12 and the third electrode 20. Therefore, since a drive circuit having one polarity can be used for driving, it is possible to reduce the cost as compared with a case where two drive circuits having different polarities are provided.

It is preferable that the piezoelectric element 1 is configured such that the first electrode 12 and the third electrode 20 are connected. In a case where the first electrode 12 and the third electrode 20 are connected, drive control is easy.

The first piezoelectric film 14 and the second piezoelectric film 18 have the spontaneous polarizations aligned in the same direction, and do not require a poling treatment. The first piezoelectric film 14 and the second piezoelectric film 18 can be formed using the same material and film formation method, so that cost reduction can be achieved.

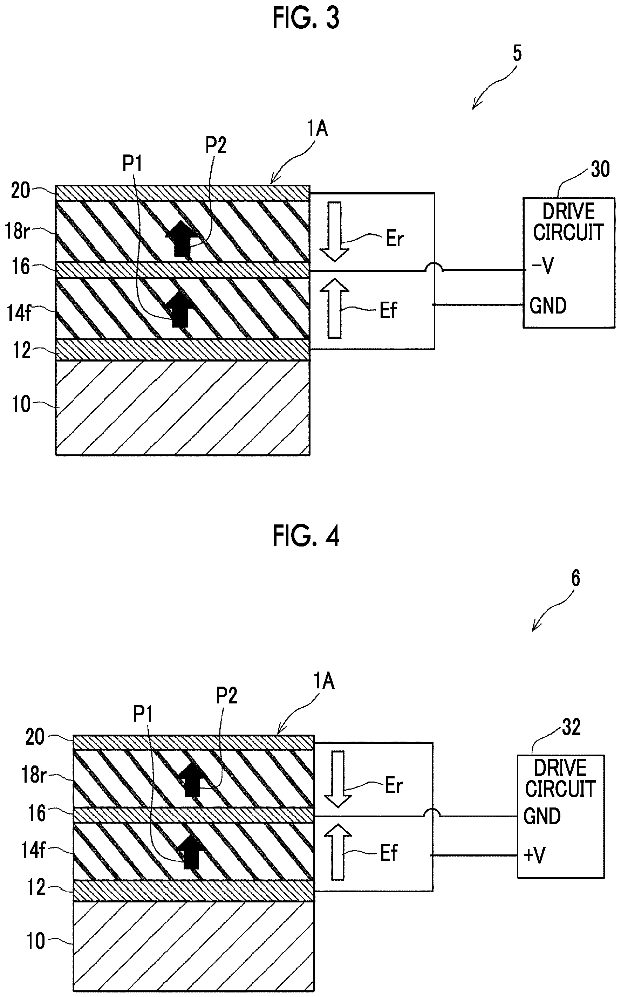

Fig. 3 shows a schematic configuration of an actuator 5 comprising a piezoelectric element 1A. In addition, in the drawings after Fig. 3, the same components as those in Fig. 1 are designated by the same references. The actuator 5 includes the piezoelectric element 1A and a drive circuit 30. In the piezoelectric element 1A shown in Fig. 3, the Pb composition ratio of the perovskite-type oxide contained in a first piezoelectric film 14f is larger than the Pb composition ratio of the perovskite-type oxide contained in a second piezoelectric film 18r. That is, the first piezoelectric film 14f is a piezoelectric film having a relatively large Pb composition ratio, and the second piezoelectric film 18r is a piezoelectric film having a relatively small Pb composition ratio.

The drive circuit 30 is means for supplying a drive voltage to the piezoelectric film sandwiched between the electrodes. In this example, the first electrode 12 and the third electrode 20 are connected to a ground terminal of the drive circuit 30 and are set to a ground potential. The second electrode 16 is connected to a drive voltage output terminal of the drive circuit 30 and functions as a drive electrode. Accordingly, the drive circuit 30 applies a drive voltage to the first piezoelectric film 14f and the second piezoelectric film 18r. In this example, the drive circuit 30 applies an electric field Ef in the same direction as the direction of the spontaneous polarization P1 to the first piezoelectric film 14f, and applies an electric field Er in a direction opposite to the direction of the spontaneous polarization P2 to the second piezoelectric film 18r. That is, the drive circuit 30 is a negative drive circuit that executes a negative drive for applying a negative potential to the drive electrode.

On the other hand, as in an actuator 6 of a modification example shown in Fig. 4, a drive circuit 32 that executes a positive drive for applying a positive potential to the drive electrode may be provided. In the example shown in Fig. 4, the second electrode 16 is connected to a ground terminal of the drive circuit 32 and is set to a ground potential. The first electrode 12 and the third electrode 20 are connected to a drive voltage output terminal of the drive circuit 32 and function as drive electrodes. In this case, since the drive circuit 32 is a positive drive circuit, the electric field Ef in the same direction as the direction of the spontaneous polarization P1 can be applied to the first piezoelectric film 14f, and the electric field Er in a direction opposite to the direction of the spontaneous polarization P2 can be applied to the second piezoelectric film 18r.

The actuators 5 and 6 comprising the piezoelectric element 1A need only be provided with a driver having one polarity and can be realized at low costs. Since the piezoelectric element 1Ais provided, large piezoelectric performance can be obtained in a low voltage region.

As described above, in the piezoelectric element 1 shown in Fig. 1, the first piezoelectric film 14 may be a piezoelectric film containing a perovskite-type oxide having a relatively small Pb composition ratio, and the second piezoelectric film 18 may be a piezoelectric film containing a perovskite-type oxide having a relatively large Pb composition ratio. The first piezoelectric film 14 containing a perovskite-type oxide having a relatively small Pb composition ratio is assumed as the first piezoelectric film 14r, and the second piezoelectric film 18 containing a perovskite-type oxide having a relatively large Pb composition ratio is assumed as the second piezoelectric film 18f.

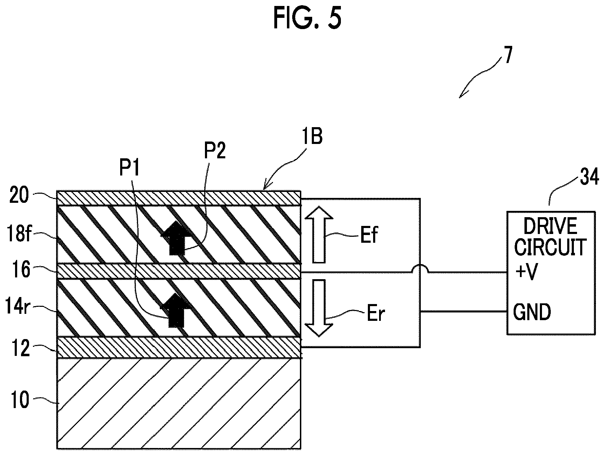

A piezoelectric element 1B shown in Fig. 5 includes the first piezoelectric film 14r and the second piezoelectric film 18f. In this case, as shown in Fig. 5, by applying the electric field Er in a direction opposite to the direction of the spontaneous polarization P1 to the first piezoelectric film 14r, and applying the electric field Ef in the same direction as the direction of the spontaneous polarization P2 to the second piezoelectric film 18f, good piezoelectric performance can be obtained in a low voltage region by a drive circuit having one polarity.

In an actuator 7 shown in Fig. 5, the first electrode 12 and the third electrode 20 are connected to a ground terminal of a drive circuit 34 and are set to a ground potential. The second electrode 16 is connected to a drive voltage output terminal of the drive circuit 34 and functions as a drive electrode. The drive circuit 34 is a positive drive circuit.

In a case where the piezoelectric element 1B is used, a configuration may be adopted in which a negative drive circuit is provided, the second electrode 16 is connected to the ground terminal to be a ground potential, and the first electrode 12 and the third electrode 20 are connected to the drive voltage output terminal to function as a drive electrode.

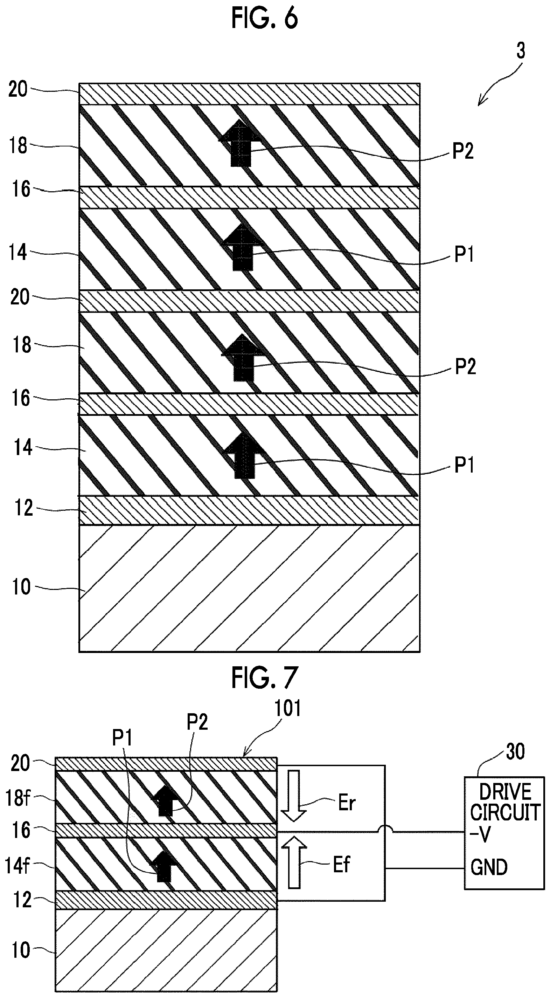

In addition, the piezoelectric element 1 shown in Fig. 1 is a two-layered piezoelectric element in which two layers of piezoelectric films including one first piezoelectric film 14 and one second piezoelectric film 18 are laminated. However, the piezoelectric element according to the present disclosure is not limited to two layers, and may include three or more layers of piezoelectric films. As in a piezoelectric element 3 shown in Fig. 6, a plurality of the first piezoelectric films 14 and a plurality of the second piezoelectric films 18 may be provided alternately. The piezoelectric element 3 has the first electrode 12, the first piezoelectric film 14, the second electrode 16, the second piezoelectric film 18, the third electrode 20, the first piezoelectric film 14, the second electrode 16, the second piezoelectric film 18, and the third electrode 20 which are laminated on the substrate 10 in this order. As described above, the first piezoelectric film 14 and the second piezoelectric film 18 having different Pb composition ratios in the M-doped PZT may be alternately provided in a plurality of layers via the electrodes.

Here, a principle in which the piezoelectric element of the present disclosure exhibits large piezoelectric performance in a low voltage region will be described.

A piezoelectric element 101 shown in Fig. 7 is a multilayered piezoelectric element for comparative purposes. In the piezoelectric element 101, the first piezoelectric film 14f and the second piezoelectric film 18f are composed of Nb-doped PZT films having the same composition and film thickness. First, the piezoelectric performance of the piezoelectric element 101 will be described (see Comparative Examples 4 to 6 described below).

Since the first piezoelectric film 14f and the second piezoelectric film 18f have the same composition and film thickness, both have the same piezoelectric characteristics, and the P-V hysteresis curves showing the polarization-voltage characteristics are substantially the same. In general, the characteristics of the piezoelectric film are discussed in terms of the P-E hysteresis curve showing the polarization-electric field (P-E) characteristics, but the behavior of the piezoelectric film in the piezoelectric element needs to consider the film thickness. Therefore, in the following, the characteristics of each piezoelectric film will be described with reference to the P-V hysteresis curve.

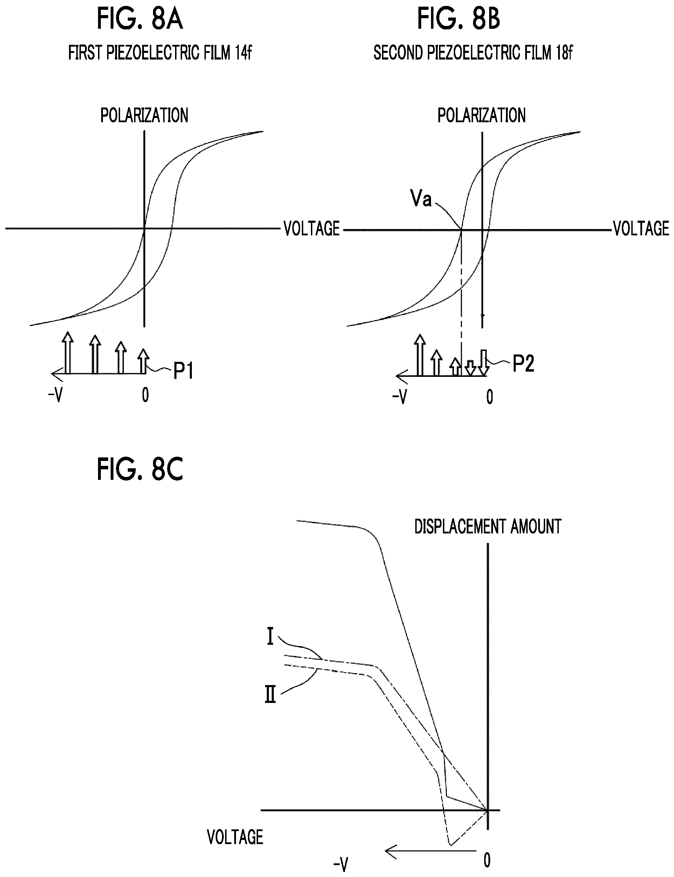

Figs. 8A and 8B show the P-V hysteresis curves of the first piezoelectric film 14f and the second piezoelectric film 18f, respectively, in a case where the first electrode 12 and the third electrode 20 are grounded and the second electrode 16 is used as a drive electrode as shown in Fig. 7. Since the first piezoelectric film 14f and the second piezoelectric film 18f have the same composition and film thickness, in a case where the lower electrode is grounded and the upper electrode is used as the drive electrode, both have the hysteresis curve of Fig. 8A. However, here, regarding the second piezoelectric film 18f, since the third electrode 20 which is an upper electrode is grounded and the second electrode 16 which is a lower electrode is used as a drive electrode, the hysteresis curve of Fig. 8B is a hysteresis curve obtained by rotating the hysteresis curve shown in Fig. 8A by 180° about the origin.

A potential of 0 to -V is applied to the second electrode 16 such that the electric field Ef in the same direction as the direction of the spontaneous polarization P1 is applied to the first piezoelectric film 14f and the electric field Er in a direction opposite to the direction of the spontaneous polarization P2 is applied to the second piezoelectric film 18f. Here, the first piezoelectric film 14f and the second piezoelectric film 18f expand and contract in an in-plane direction in a d₃₁ mode with the application of a voltage, and the substrate 10 bends with the expansion and contraction of these piezoelectric films. Fig. 8C schematically shows a voltage dependence of a displacement amount of one point of the substrate 10 in this case.

In a case where the potential applied to the second electrode 16 in Fig. 7 is changed from 0 to -V, an electric field in the same direction as the direction of the spontaneous polarization P1 is applied to the first piezoelectric film 14f. Therefore, as shown by arrows below the hysteresis curve in Fig. 8A, the magnitude of the polarization gradually increases in the same direction as the direction of the spontaneous polarization P1 as the potential changes from 0 to -V. Therefore, the displacement amount in a case where a voltage of 0 to -V is applied only to the first piezoelectric film 14f increases as V increases, as shown by the one-dot chain line I in Fig. 8C. In a case where the drive potential applied to the second electrode 16 in Fig. 7 is changed from 0 to -V, the electric field Er in a direction opposite to the direction of the spontaneous polarization P2 is applied to the second piezoelectric film 18f. Therefore, as shown by arrows below the hysteresis curve in Fig. 8B, as the applied potential changes from 0 to -V, the polarization in the direction of the spontaneous polarization P2 gradually decreases, and the polarization in the same direction as the electric field gradually increases after the polarization is reversed at a coercive voltage Va. Therefore, as shown by the broken line II in Fig. 8C, the displacement amount in a case where a voltage of 0 to -V is applied only to the second piezoelectric film 18f is displaced in the opposite direction up to the coercive voltage at which a value of the polarization is 0. In a case where the first piezoelectric film 14f and the second piezoelectric film 18f are driven at the same time, as shown by the solid line in Fig. 8C, they behave such that the displacement amounts of both are added. Therefore, in a case where the first piezoelectric film 14f and the second piezoelectric film 18f are driven at the same time, a very large displacement amount can be obtained on the high voltage side, but the displacement amount in the low voltage region is smaller than the displacement amount obtained with only one layer of a piezoelectric film.

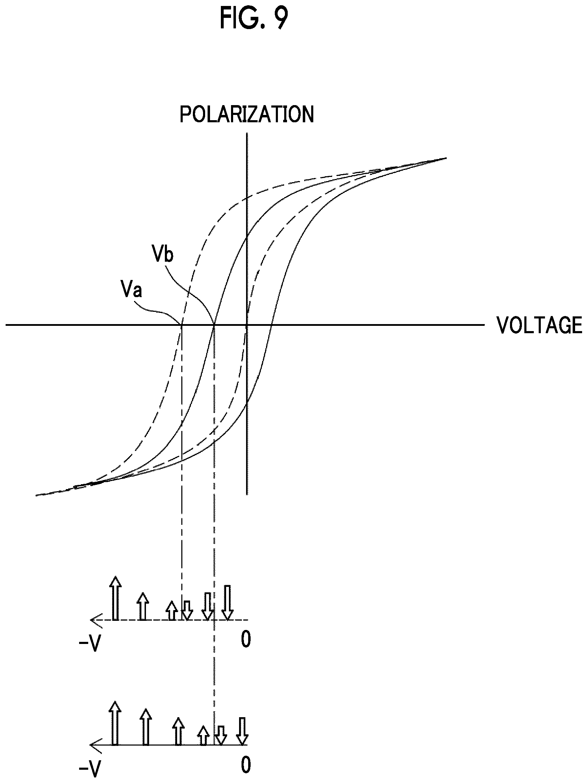

On the other hand, for example, in the piezoelectric element 1A shown in Fig. 3, the coercive voltage of the second piezoelectric film 18r to which the electric field in a direction opposite to the direction of the spontaneous polarization P2 is applied is smaller than the coercive voltage of the first piezoelectric film 14f to which the electric field in the same direction as the direction of the spontaneous polarization P1 is applied. Here, the hysteresis curve obtained with respect to the second piezoelectric film 18r using the second electrode 16 as a drive electrode and the hysteresis curve shown in Fig. 8B are shown superimposed in Fig. 9. In Fig. 9, the hysteresis curve shown by the broken line is the hysteresis curve shown in Fig. 8B, and the hysteresis curve shown by the solid line is that of the second piezoelectric film 18r of the piezoelectric element 1A. A coercive voltage Vb of the solid line hysteresis curve is located closer to the origin side than the coercive voltage Va of the broken line hysteresis curve. That is, as schematically shown below the hysteresis in Fig. 9, in a case where a drive voltage for applying an electric field in a direction opposite to the direction of the spontaneous polarization P2 is applied to the second piezoelectric film 18r of the piezoelectric element 1A, polarization reversal occurs on the lower voltage side than in a case where a drive voltage for applying an electric field in a direction opposite to the direction of the spontaneous polarization P2 is applied to the piezoelectric film showing the broken line hysteresis curve, that is, the second piezoelectric film 18f of the piezoelectric element 101.

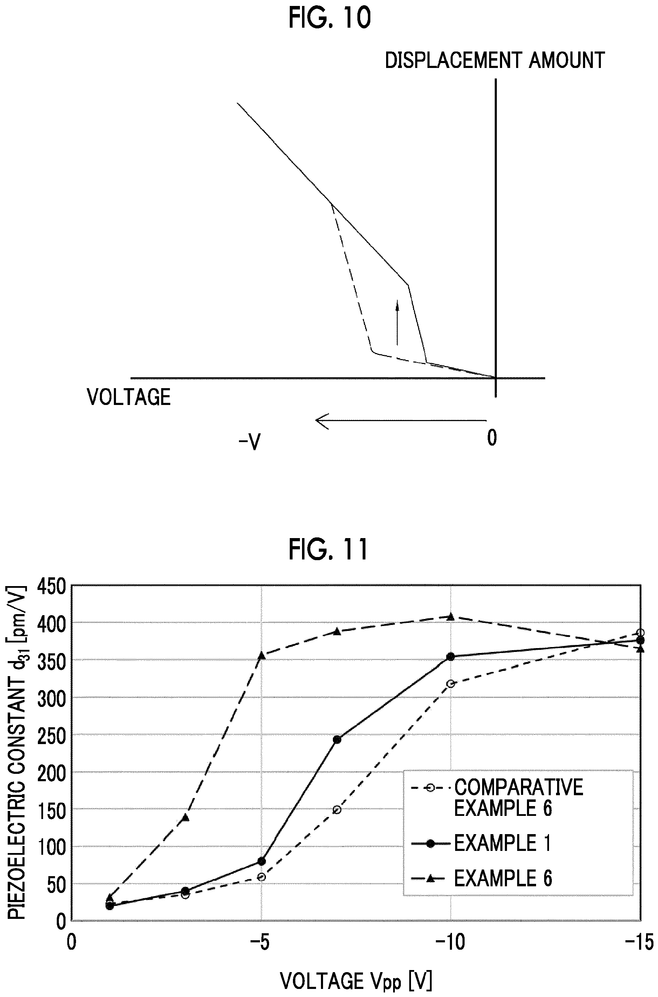

Fig. 10 is a schematic diagram of a voltage dependence of the displacement amount, in which a change in the displacement amount in a case where the piezoelectric element 101 of Fig. 7 is driven with a drive voltage of 0 to -V is shown by the broken line, and a change in the displacement amount in a case where the piezoelectric element 1A in Fig. 3 is driven with a drive voltage of 0 to -V is shown by the solid line. As shown in Fig. 10, in a case where a drive voltage of 0 to -V is applied, the piezoelectric element 1A can obtain a large displacement in a low voltage region as compared with the piezoelectric element 101 of Fig. 7.

### Examples

Hereinafter, specific examples and comparative examples of the piezoelectric element according to the present disclosure will be described.

First, a production method for a piezoelectric element of each example will be described. The description of the manufacturing method will be made with reference to the references of the respective layers of the piezoelectric element 1 shown in Fig. 1.

For Comparative Examples 1 to 3, the first electrode 12, the first piezoelectric film 14, and the second electrode 16 were sputter-deposited on the substrate 10 in this order to prepare a laminate. That is, Comparative Examples 1 to 3 are piezoelectric elements comprising a single layer of a piezoelectric film.

In Comparative Examples 4 to 6 and Examples, the first electrode 12, the first piezoelectric film 14, the second electrode 16, the second piezoelectric film 18, and the third electrode 20 were sputter-deposited on the substrate 10 in this order to prepare a laminate. That is, Comparative Examples 4 to 6 and Examples are multilayered piezoelectric elements comprising two layers of piezoelectric films.

A radio frequency (RF) sputtering device was used for the deposition of each layer. Materials and deposition conditions (sputtering conditions) of respective layers were as follows.

### Substrate

A thermal oxide film-attached silicon substrate was used as the substrate 10.

### Deposition of First Electrode

As the first electrode 12, a Ti layer having a thickness of 20 nm and an Ir layer having a thickness of 150 nm were laminated on the substrate 10 in this order. The sputtering conditions for respective layers were as follows.

### Sputtering Conditions for Ti Layer

Distance between target and substrate: 100 mm
Target input power: 600 W
Ar gas pressure: 0.5 Pa
Set temperature of substrate: 350°C

### Sputtering Conditions for Ir Layer

Distance between target and substrate: 100 mm
Target input power: 600 W
Ar gas pressure: 0.1 Pa
Set temperature of substrate: 350°C

### First Piezoelectric Film and Second Piezoelectric Film

A Nb-doped PZT in which a Nb addition amount to the B-site is 12 at% was used as a target, and a film was formed under the following sputtering conditions. An amount of Pb in the target was set to a = 1.3, which is larger than a stoichiometric composition, and a Ti/Zr molar ratio was set to the MPB composition (Ti/Zr = 52/48).

### Sputtering Conditions for First Layer

Distance between target and substrate: 60 mm
Target input power: 500 W
Vacuum degree: 0.3 Pa, an Ar/O₂ mixed atmosphere (O₂ volume fraction: 10%)
Set temperature of substrate: 550°C to 600°C

The set temperature of the substrate was appropriately set for each piezoelectric film of each example in order to control the Pb composition ratio in the piezoelectric film after the film formation. A relationship between the Pb composition ratio in the piezoelectric film (see Table 1) and the set temperature of the substrate is as follows.
Pb composition ratio 1.1: 600°C
Pb composition ratio 1.11: 575°C
Pb composition ratio 1.12: 550°C

For example, the first piezoelectric film according to Comparative Example 1 in which the Pb composition ratio a = Pb/(Zr + Ti + Nb) after film formation is 1.1 was formed at the set temperature of the substrate of 600°C and the first piezoelectric film according to Comparative Example 2 in which the Pb composition ratio a is 1.11 was formed at the set temperature of 575°C.

The film thicknesses of the first piezoelectric film 14 and the second piezoelectric film 18 in each example were as shown in Table 1. The film thickness was adjusted by changing a film formation time. In each example, it was confirmed with an optical interference film thickness meter that a desired film thickness was obtained.

In addition, a composition of each piezoelectric film was confirmed by X-ray fluorescence (XRF) analysis. The Pb composition ratio for each example is as shown in Table 1, and the relationship between the Pb composition ratio and the set temperature of the substrate was confirmed. In addition, the composition ratios x and y other than Pb were confirmed to coincide in an error range (here, a range of ±0.005) for each example.

### Second Electrode and Third Electrode

As the second electrode 16 and the third electrode 20, IrO_{z} (z ≤ 2) of 50 nm and Ir of 100 nm were laminated in this order, respectively.

### Sputtering Conditions for IrO_{z} and Ir

Distance between target and substrate: 100 mm
Target input power: 200 W
Vacuum degree: 0.3Pa, an Ar atmosphere during Ir film formation, an Ar/O₂ mixed atmosphere during IrO_{z} film formation (O₂ volume fraction: 5%)
Set Temperature of Substrate: Room Temperature

### Formation of Electrode Pattern for Evaluation

In Comparative Examples 1 to 3, in order to form electrode pads for applying a voltage to the first electrode 12 and the second electrode 16, the second electrode 16 and the first piezoelectric film 14 were sequentially patterned by photolithography and dry etching.

In Comparative Examples 4 to 6 and Examples, in order to form electrode pads for applying a voltage to the first electrode 12, the second electrode 16, and the third electrode 20, the third electrode 20, the second piezoelectric film 18, the second electrode 16, and the first piezoelectric film 14 were sequentially patterned by photolithography and dry etching.

### Evaluation Sample

A strip-shaped portion of 2 mm × 25 mm was cut out from the laminate of each example to prepare a cantilever as an evaluation sample.

### Measurement of Piezoelectric Constant

For each Example and Comparative Example, a piezoelectric constant d₃₁ was measured using the cantilever prepared as described above. According to a method described in I. Kanno et al., Sensor and Actuator A 107 (2003) 68, the measurement was performed with an application voltage of a sinusoidal wave of -α ± αV (that is, Vpp = -2α). The sinusoidal wave of -α ± αV is a drive signal obtained by adding a sinusoidal wave having an amplitude of αV to a bias voltage of -αV. For example, Vpp = -10 means that a drive signal obtained by adding a sinusoidal wave having an amplitude of 5 V to a bias voltage of -5 V is used. In this example, the first electrode 12 and the third electrode 20 were grounded, the second electrode 16 was used as a drive electrode, and a drive signal was applied to the second electrode 16 for measurement. The results are shown in Table 1. The piezoelectric constant d₃₁ shown in Table 1 is a value measured with a drive signal of Vpp = -10.

In this example, since the first electrode 12 and the third electrode 20 were grounded and the second electrode 16 was used as the drive electrode, in the piezoelectric element having a two-layer structure comprising the first piezoelectric film 14 and the second piezoelectric film 18, the electric field in the same direction as the direction of the spontaneous polarization was applied to the first piezoelectric film 14, and the electric field in a direction opposite to the direction of the spontaneous polarization was applied to the second piezoelectric film 18.

**Table 1**

| | First Piezoelectric Film | | Second Piezoelectric Film | | Piezoelectric Constant d₃₁ [Pm/V] @ -10 Vpp |
|---|---|---|---|---|---|
| | Pb Composition Ratio | Film Thickness [µm] | Pb Composition Ratio | Film Thickness [µm] | |
| Comparative Example 1 | 1.10 | 2 | - | - | 181 |
| Comparative Example 2 | 1.11 | 2 | - | - | 202 |
| Comparative Example 3 | 1.12 | 2 | - | - | 218 |
| Comparative Example 4 | 1.10 | 2 | 1.10 | 2 | 317 |
| Comparative Example 5 | 1.11 | 2 | 1.11 | 2 | 328 |
| Comparative Example 6 | 1.12 | 2 | 1.12 | 2 | 318 |
| Example 1 | 1.12 | 2 | 1.10 | 2 | 354 |
| Example 2 | 1.12 | 2 | 1.11 | 2 | 344 |
| Example 3 | 1.12 | 2 | 1.11 | 2.1 | 340 |
| Example 4 | 1.12 | 2 | 1.10 | 1.9 | 381 |
| Example 5 | 1.12 | 2 | 1.10 | 1.5 | 395 |
| Example 6 | 1.12 | 2 | 1.10 | 1 | 408 |
| Example 7 | 1.12 | 2.5 | 1.10 | 1 | 398 |
| Example 8 | 1.12 | 1.8 | 1.10 | 1 | 413 |
| Example 9 | 1.12 | 1.5 | 1.10 | 1 | 419 |
| Example 10 | 1.12 | 1 | 1.10 | 1 | 365 |

As shown in Comparative Examples 1 to 3, in the piezoelectric element in which the piezoelectric film is a single layer, a higher piezoelectric constant d₃₁ was obtained as the Pb composition ratio increased from 1.10 to 1.12. On the other hand, in Comparative Examples 4 to 6 in which two layers having the same composition were laminated, a rate of increase of the piezoelectric constant d₃₁ in a case of two layers was lower as the piezoelectric constant was higher with the single layer.

In Examples 1 to 10, higher piezoelectric constants were obtained than in Comparative Examples 4 to 6. In Examples 1 to 10, the Pb composition ratio of the first piezoelectric film 14 and the Pb composition ratio of the second piezoelectric film 18 are different from each other. In Examples 1 to 10, a difference between the Pb composition ratios is at least 0.01 or more. As shown in Examples 1 and 2, a higher piezoelectric constant was obtained as the difference in the Pb composition ratio between the first piezoelectric film 14 and the second piezoelectric film 18 was larger. In addition, as shown in Examples 2 and 3, a higher piezoelectric constant was obtained in a case where the film thickness of the second piezoelectric film 18 having a smaller Pb composition ratio was smaller than that of the film thickness of the first piezoelectric film 14.

As shown in Examples 1 and 4 to 6, a higher piezoelectric constant was obtained as the film thickness of the second piezoelectric film 18 having a smaller Pb composition ratio is thinner. In a case where the film thickness of the second piezoelectric film 18 is thinner than the film thickness of the first piezoelectric film 14 by 100 nm or more as in Examples 4 to 6, the piezoelectric constant which is at least 1.1 times that of a case where the film thicknesses of both are the same was obtained.

As shown in Examples 6 to 10, in a case where the film thickness of the second piezoelectric film 18 having a smaller Pb composition ratio is fixed, a higher piezoelectric constant was obtained in a case where the film thickness of the first piezoelectric film 14 is 1.5 to 2.5 times the film thickness of the second piezoelectric film 18, as compared with a case where the film thicknesses of both are the same.

For Comparative Example 1, Example 1, and Example 6, the voltage dependence of the piezoelectric constant d₃₁ was measured. The results are shown in Fig. 11. As shown in Fig. 11, in Examples 1 and 6, even in a region of a lower voltage of -7 Vpp, a larger piezoelectric constant d₃₁ was obtained as compared with Comparative Example 6. In particular, in Example 6, a piezoelectric constant close to three times that of Comparative Example 6 was obtained at a very low voltage of -3 Vpp, and the piezoelectric constant d₃₁ exceeding 350 pm/V was obtained at -5 Vpp.

As described above, it is clear that Examples 1 to 10 have higher piezoelectric performance in a low voltage region of 10 V or less than a configuration in which two piezoelectric films having the same composition are simply laminated.

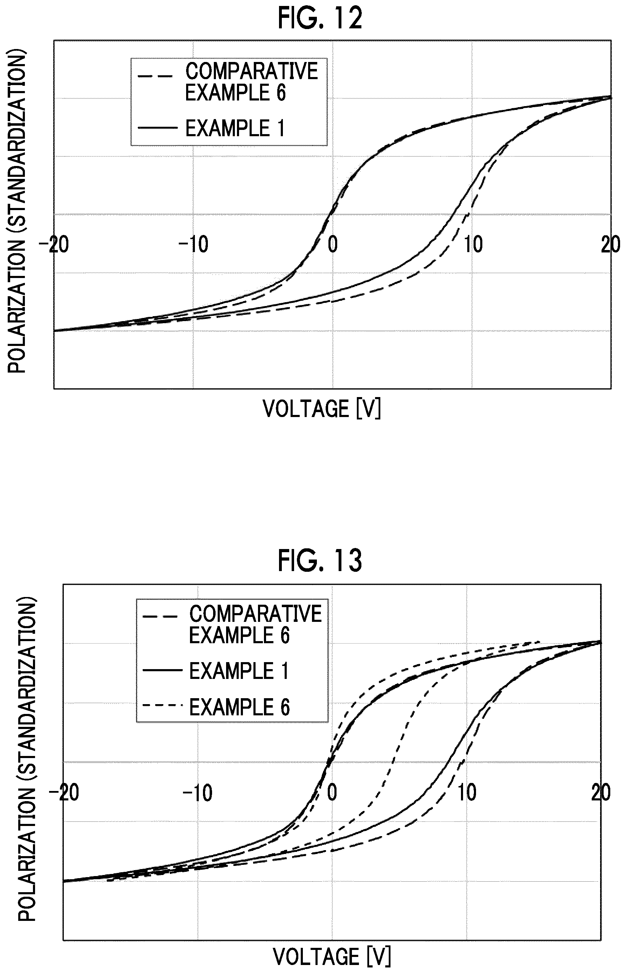

Further, Figs. 12 and 13 show the results of measuring the polarization-voltage hysteresis curves showing the polarization-voltage characteristics of the second piezoelectric films of Comparative Example 6, Example 1, and Example 6.

As shown in Fig. 12, a coercive voltage (8V) on the positive side in the hysteresis curve (indicated by the solid line in Fig. 12) of the second piezoelectric film of Example 1 is smaller than a coercive voltage (10V) on the positive side of the hysteresis curve (indicated by the broken line in Fig. 12) of the second piezoelectric film of Comparative Example 6. During driving, an electric field in a direction opposite to the direction of the spontaneous polarization is applied to the second piezoelectric film. In this case, the piezoelectric performance is low on the low voltage side up to the coercive voltage on the positive side where the polarization reversal occurs. The coercive voltage on the positive side of the second piezoelectric film of Example 1 is smaller than the coercive voltage on the positive side of the second piezoelectric film of Comparative Example 6, that is, the voltage at which the spontaneous polarization is reversed is smaller for the second piezoelectric film of Example 1 than for the second piezoelectric film of Comparative Example 6. Therefore, it is considered that Example 1 obtained a larger piezoelectric constant d₃₁ than that of Comparative Example 6 on the lower voltage side.

Further, as shown in Fig. 13, the coercive voltage on the positive side of the hysteresis curve (indicated by the one-dot chain line in Fig. 13) of the second piezoelectric film of Example 6 is about 4V, which is about half that of Example 1. Fig. 13 also shows the hysteresis of Comparative Example 6 and Example 1 shown in Fig. 12. The coercive electric field of the piezoelectric film depends on the material of the piezoelectric film. However, since the coercive voltage is the product of the coercive electric field and the film thickness, even with the same material, in a case where the film thickness is halved, the coercive voltage will be halved. It is considered that due to this effect, in Example 6, a large piezoelectric constant d₃₁ is obtained even in a very low voltage region of 3 V to 5 V, as shown in Fig. 11.

## Claims

1. A piezoelectric element (1) comprising:
a substrate (10); and
a first electrode (12), a first piezoelectric film (14), a second electrode (16), a second piezoelectric film (18), and a third electrode (20) which are provided on the substrate in this order,
wherein both the first piezoelectric film and the second piezoelectric film contain a perovskite-type oxide containing Pb at an A site and containing Zr, Ti, and M at a B site as a main component, where M is a metal element selected from V, Nb, Ta, Sb, Mo, and W,
in a case where a Pb composition ratio in the perovskite-type oxide is defined by Pb/(Zr + Ti + M), where element symbols each represent a molar ratio, the Pb composition ratio in the first piezoelectric film is different from the Pb composition ratio in the second piezoelectric film,
both the first piezoelectric film and the second piezoelectric film have spontaneous polarizations (P1, P2) aligned in a film thickness direction, and directions of the spontaneous polarizations of the first piezoelectric film and the second piezoelectric film are the same, and
polarization-electric field hysteresis measured for the first piezoelectric film with the first electrode grounded and the second electrode as a drive electrode, and polarization-electric field hysteresis measured for the second piezoelectric film with the second electrode grounded and the third electrode as a drive electrode are shifted in the same electric field direction with respect to origins thereof.

2. The piezoelectric element according to claim 1, wherein at the B sites of the perovskite-type oxides contained in the first piezoelectric film and the second piezoelectric film, Zr composition ratios represented by Zr/(Zr + Ti), Ti composition ratios represented by Ti/(Zr + Ti), and M composition ratios represented by M/(Zr + Ti + M) are the same, respectively.

3. The piezoelectric element according to claim 2, wherein in a case where the metal element M is Nb and the M composition ratio at the B site is y, 0.08 ≤ y ≤ 0.15 is satisfied.

4. The piezoelectric element according to any one of claims 1 to 3, wherein the Pb composition ratio of the perovskite-type oxide contained in the first piezoelectric film and the Pb composition ratio of the perovskite-type oxide contained in the second piezoelectric film differ from each other by 0.01 or more.

5. The piezoelectric element according to any one of claims 1 to 3, wherein, out of the first piezoelectric film and the second piezoelectric film, a film thickness of the piezoelectric film having a relatively small Pb composition ratio is thinner than a film thickness of the piezoelectric film having a relatively large Pb composition ratio by 100 nm or more.

6. The piezoelectric element according to claim 5, wherein the film thickness of the piezoelectric film having a relatively small Pb composition ratio is 1.5 µm or less.

7. The piezoelectric element according to claim 5, wherein the film thickness of the piezoelectric film having a relatively large Pb composition ratio is 2 µm or less.

8. The piezoelectric element according to any one of claims 1 to 7, wherein the first electrode and the third electrode are connected to each other.

9. The piezoelectric element according to any one of claims 1 to 8, wherein, out of the first piezoelectric film and the second piezoelectric film, an electric field in the same direction as the direction of the spontaneous polarization is applied to the piezoelectric film having a relatively large Pb composition ratio, and an electric field in a direction opposite to the direction of the spontaneous polarization is applied to the piezoelectric film having a relatively small Pb composition ratio.

10. An actuator comprising:
the piezoelectric (5, 6, 7) element according to any one of claims 1 to 9; and
a drive circuit (30, 32, 34) that applies a drive voltage to the piezoelectric element,
wherein the drive circuit applies an electric field in the same direction as the direction of the spontaneous polarization to the piezoelectric film having a relatively large Pb composition ratio, and applies an electric field in a direction opposite to the direction of the spontaneous polarization to the piezoelectric film having a relatively small Pb composition ratio, out of the first piezoelectric film and the second piezoelectric film.

## Patentansprüche

1. Piezoelektrisches Element (1), umfassend:
ein Substrat (10); und
eine erste Elektrode (12), einen ersten piezoelektrischen Film (14), eine zweite Elektrode (16), einen zweiten piezoelektrischen Film (18) und eine dritte Elektrode (20), die in dieser Reihenfolge auf dem Substrat vorgesehen sind,
wobei sowohl der erste piezoelektrische Film als auch der zweite piezoelektrische Film ein Oxid des Perowskit-Typs enthalten, das Pb an einer A-Stelle enthält und Zr, Ti und M an einer B-Stelle als eine Hauptkomponente enthält, wobei M ein Metallelement ist, das aus V, Nb, Ta, Sb, Mo und W ausgewählt ist,
in einem Fall, in dem ein Pb-Zusammensetzungsverhältnis bei dem Oxid des Perowskit-Typs durch Pb/(Zr + Ti + M) definiert ist, wobei Elementsymbole jeweils ein Molverhältnis darstellen, das Pb-Zusammensetzungsverhältnis bei dem ersten piezoelektrischen Film von dem Pb-Zusammensetzungsverhältnis bei dem zweiten piezoelektrischen Film unterschiedlich ist,
sowohl der erste piezoelektrische Film als auch der zweite piezoelektrische Film spontane Polarisationen (P1, P2) aufweisen, die in einer Filmdickenrichtung ausgerichtet sind, und Richtungen der spontanen Polarisationen des ersten piezoelektrischen Films und des zweiten piezoelektrischen Films gleich sind, und
Hysterese durch Polarisation von elektrischem Feld, die für den ersten piezoelektrischen Film gemessen wird, wobei die erste Elektrode geerdet ist und die zweite Elektrode als eine Antriebselektrode verwendet wird, und Hysterese durch Polarisation von elektrischem Feld, die für den zweiten piezoelektrischen Film gemessen wird, wobei die zweite Elektrode geerdet ist und die dritte Elektrode als eine Antriebselektrode verwendet wird, in Bezug auf Ursprünge davon in der gleichen Richtung von elektrischem Feld verschoben sind.

2. Piezoelektrisches Element nach Anspruch 1, wobei an den B-Stellen der in dem ersten piezoelektrischen Film und dem zweiten piezoelektrischen Film enthaltenen Oxide des Perowskit-Typs Zr-Zusammensetzungsverhältnisse, die durch Zr/(Zr + Ti) dargestellt sind, Ti-Zusammensetzungsverhältnisse, die durch Ti/(Zr + Ti) dargestellt sind, und M-Zusammensetzungsverhältnisse, die durch M/(Zr + Ti + M) dargestellt sind, entsprechend gleich sind.

3. Piezoelektrisches Element nach Anspruch 2, wobei in einem Fall, in dem das Metallelement M Nb ist und das M-Zusammensetzungsverhältnis an der B-Stelle y ist, 0,08 ≤ y ≤ 0,15 erfüllt ist.

4. Piezoelektrisches Element nach einem der Ansprüche 1 bis 3, wobei sich das Pb-Zusammensetzungsverhältnis des in dem ersten piezoelektrischen Film enthaltenen Oxids des Perowskit-Typs und das Pb-Zusammensetzungsverhältnis des in dem zweiten piezoelektrischen Film enthaltenen Oxids des Perowskit-Typs um 0,01 oder mehr voneinander unterscheiden.

5. Piezoelektrisches Element nach einem der Ansprüche 1 bis 3, wobei von dem ersten piezoelektrischen Film und dem zweiten piezoelektrischen Film eine Filmdicke des piezoelektrischen Films, der ein relativ kleines Pb-Zusammensetzungsverhältnis aufweist, um 100 nm oder mehr dünner als eine Filmdicke des piezoelektrischen Films, der ein relativ großes Pb-Zusammensetzungsverhältnis aufweist, ist.

6. Piezoelektrisches Element nach Anspruch 5, wobei die Filmdicke des piezoelektrischen Films mit einem relativ kleinen Pb-Zusammensetzungsverhältnis 1,5 µm oder weniger beträgt.

7. Piezoelektrisches Element nach Anspruch 5, wobei die Filmdicke des piezoelektrischen Films mit einem relativ großen Pb-Zusammensetzungsverhältnis 2 µm oder weniger beträgt.

8. Piezoelektrisches Element nach einem der Ansprüche 1 bis 7, wobei die erste Elektrode und die dritte Elektrode miteinander verbunden sind.

9. Piezoelektrisches Element nach einem der Ansprüche 1 bis 8, wobei von dem ersten piezoelektrischen Film und dem zweiten piezoelektrischen Film ein elektrisches Feld in der gleichen Richtung wie die Richtung der spontanen Polarisation an den piezoelektrischen Film mit einem relativ großen Pb-Zusammensetzungsverhältnis angelegt wird und ein elektrisches Feld in einer Richtung, die zu der Richtung der spontanen Polarisation entgegengesetzt ist, an den piezoelektrischen Film mit einem relativ kleinen Pb-Zusammensetzungsverhältnis angelegt wird.

10. Aktuator, umfassend:
das piezoelektrische (5, 6, 7) Element nach einem der Ansprüche 1 bis 9; und
eine Antriebsschaltung (30, 32, 34), der eine Antriebsspannung an das piezoelektrische Element anlegt,
wobei von dem ersten piezoelektrischen Film und dem zweiten piezoelektrischen Film die Antriebsschaltung ein elektrisches Feld in der gleichen Richtung wie die Richtung der spontanen Polarisation an den piezoelektrischen Film mit einem relativ großen Pb-Zusammensetzungsverhältnis anlegt und ein elektrisches Feld in einer Richtung, die der Richtung der spontanen Polarisation entgegengesetzt ist, an den piezoelektrischen Film mit einem relativ kleinen Pb-Zusammensetzungsverhältnis anlegt.

## Revendications

1. Elément piézoélectrique (1) comprenant :
un substrat (10) ; et
une première électrode (12), un premier film piézoélectrique (14), une deuxième électrode (16), un deuxième film piézoélectrique (18) et une troisième électrode (20) qui sont prévus sur le substrat dans cet ordre,
dans lequel à la fois le premier film piézoélectrique et le deuxième film piézoélectrique contiennent un oxyde de type pérovskite contenant de Pb dans un site A et contenant de Zr, Ti et M dans un site B en tant que composant principal, où M est un élément métallique choisi parmi V, Nb, Ta, Sb, Mo et W,
dans un cas où un rapport de composition de Pb dans l'oxyde de type pérovskite est défini par Pb/(Zr + Ti + M), où des symboles d'éléments représentent chacun un rapport molaire, le rapport de composition de Pb dans le premier film piézoélectrique est différent du rapport de composition de Pb dans le deuxième film piézoélectrique,
à la fois le premier film piézoélectrique et le deuxième film piézoélectrique ont des polarisations spontanées (P1, P2) alignés dans une direction d'épaisseur de film, et des directions des polarisations spontanées du premier film piézoélectrique et du deuxième film piézoélectrique sont les mêmes, et
une hystérésis de champ électrique de polarisation mesurée pour le premier film piézoélectrique avec la première électrode mise à terre et la deuxième électrode comme électrode de commande, et une hystérésis de champ électrique de polarisation mesurée pour le deuxième film piézoélectrique avec la deuxième électrode mise à terre et la troisième électrode comme électrode de commande sont décalées dans la même direction de champ électrique par rapport à leurs origines.

2. Elément piézoélectrique selon la revendication 1, dans lequel aux sites B des oxydes de type pérovskite contenus dans le premier film piézoélectrique et le deuxième film piézoélectrique, des rapports de composition de Zr représentés par Zr/(Zr + Ti), des rapports de composition de Ti représentés par Ti/(Zr + Ti) et des rapports de composition de M représentés par M/(Zr + Ti + M) sont les mêmes, respectivement.

3. Elément piézoélectrique selon la revendication 2, dans lequel dans un cas où l'élément métallique M est Nb et le rapport de composition de M au site B est y, 0,08 ≤ y ≤ 0,15 est satisfait.

4. Elément piézoélectrique selon l'une quelconque des revendications 1 à 3, dans lequel le rapport de composition de Pb de l'oxyde de type pérovskite contenu dans le premier film piézoélectrique et le rapport de composition de Pb de l'oxyde de type pérovskite contenu dans le deuxième film piézoélectrique diffèrent l'un de l'autre de 0,01 ou plus.

5. Elément piézoélectrique selon l'une quelconque des revendications 1 à 3, dans lequel, parmi le premier film piézoélectrique et le deuxième film piézoélectrique, une épaisseur de film du film piézoélectrique ayant un rapport de composition de Pb relativement faible est inférieure à une épaisseur de film du film piézoélectrique ayant un rapport de composition de Pb relativement élevé de 100 nm ou plus.

6. Elément piézoélectrique selon la revendication 5, dans lequel l'épaisseur de film du film piézoélectrique ayant un rapport de composition de Pb relativement faible est de 1,5 µm ou moins.

7. Elément piézoélectrique selon la revendication 5, dans lequel l'épaisseur de film du film piézoélectrique ayant un rapport de composition de Pb relativement élevé est de 2 µm ou moins.

8. Elément piézoélectrique selon l'une quelconque des revendications 1 à 7, dans lequel la première électrode et la troisième électrode sont connectées l'une à l'autre.

9. Elément piézoélectrique selon l'une quelconque des revendications 1 à 8, dans lequel, parmi le premier film piézoélectrique et le deuxième film piézoélectrique, un champ électrique dans la même direction que la direction de la polarisation spontanée est appliqué au film piézoélectrique ayant un rapport de composition de Pb relativement élevé, et un champ électrique dans une direction opposée à la direction de la polarisation spontanée est appliqué au film piézoélectrique ayant un rapport de composition de Pb relativement faible.

10. Actionneur comprenant :
l'élément piézoélectrique (5, 6, 7) selon l'une quelconque des revendications 1 à 9 ; et
un circuit de commande (30, 32, 34) qui applique une tension de commande à l'élément piézoélectrique,
dans lequel le circuit de commande applique un champ électrique dans la même direction que la direction de la polarisation spontanée au film piézoélectrique ayant un rapport de composition de Pb relativement élevé et applique un champ électrique dans une direction opposée à la direction de la polarisation spontanée au film piézoélectrique ayant un rapport de composition de Pb relativement faible, parmi le premier film piézoélectrique et le deuxième film piézoélectrique.
